# EUROPEAN PATENT APPLICATION

(11) **EP 1 422 748 A1**
(43) Date of publication of application: **26.05.2004**
(21) Application number: 02751808.3
(22) Date of filing: 30.07.2002
(51) Int. Cl.: H01L 21/205, H01L 21/3065

(54) **GROUP III NITRIDE SEMICONDUCTOR FILM AND ITS PRODUCTION METHOD**

(30) Priority: 01.08.2001 JP 2001233011
(71) Applicant: Nagoya Industrial Science Research Institute, Nagaya-shi, Aichi 460-0008 (JP)
(72) Inventor: HIRAMATSU, Kazumasa, Yokkaichi-shi, Mie 510-0822 (JP); MIYAKE, Hideto, Hisai-shi, Mie 514-1113 (JP); YOSHIDA, Harumasa, Shuchi-gun, Shizuoka 437-0225 (JP); URUSHIDO, Tatsuhiro, 2-77, Edobashi, Tsu-shi, Mie 514-0001 (JP); TERADA, Yusuke, Kouga-gun, Shiga 529-1812 (JP)
(74) Representative: Lippert, Marianne
(86) International application number: PCT/JP2002/007748
(87) International publication number: WO 2003/015143

(57) **Abstract**

A group **III** nitride semiconductor film involving few lattice defects and having a large thickness, and a process for making the film are disclosed. Dry-etching is conducted while a quartz substrate and a group **III** nitride semiconductor are placed on the top of a lower electrode. Nano-pillars (50) are formed on the top of the group **III** nitride semiconductor (101). Another group **III** nitride semiconductor film (51) is deposited on the nano-pillars (50).

## Description

### TECHNICAL FIELD

The present invention relates to a group **III** nitride semiconductor film and a method of fabricating the same.

### BACKGROUND ART

A group **III** nitride semiconductor film, for example, a mixed crystal AlₓGa_{y}In_{1-x-y}N (0≤x≤1, 0≤y≤1 and 0≤x+y≤1) made by mixing GaN, Al or In at a suitable ratio has an energy gap ranging from 0.75 eV to 6.288 eV and is a direct transition type semiconductor. Accordingly, the group **III** nitride semiconductor has eminent characteristics in a luminous efficiency as compared with materials belonging to an indirect transition type such as SiC and is suitable for a material for light emitting diodes, laser diodes, ultraviolet ray detecting elements and the like.

No methods have been known of fabricating a group **III** nitride semiconductor film having fine quality, large thickness and large area. Accordingly, a buffer layer of AlN or GaN is formed on a substrate differing from the group **III** nitride semiconductor film in a lattice constant and a thermal expansion coefficient, such as sapphire, SiC, Si or GaAs. GaN is formed on the buffer layer by an epitaxial growth method. For example, a known light-emitting chip of blue LED employing GaN has a double heterostructure in which a GaN buffer layer, n-type GaN layer, n-type GaAlN layer, InGaN layer, p-type GaAlN layer and p-type GaN layer are sequentially laminated on a sapphire substrate.

However, in the method of fabricating a group III nitride semiconductor film on the sapphire substrate, a GaN film has a large number of lattice defects due to a difference in the lattice constant between a grown GaN film and the substrate. Accordingly, in order that a group **III** nitride semiconductor film having fewer lattice defects and a large film thickness may be made, an epitaxial lateral overgrowth (ELO) using a stripe mask (for example, JP-A-10-312971) or re-growth after partial elimination by etching (PENDEO) is carried out in order that a group **III** nitride semiconductor film having fewer lattice defects and a large film thickness may be made.

Thus, ELO and PENDEO have been devised to make a GaN film with fewer lattice defects. However, spaces between growth starting parts are in the order of micrometers and relatively larger. Accordingly, the film is grown while lattice defects are transferred from lower layers to upper ones, whereupon a uniform crystal film involving fewer lattice defects cannot be obtained. Furthermore, a high purity group **III** nitride semiconductor film cannot be obtained in ELO by the influence of contamination by SiO₂ which is a mask material.

Furthermore, no electrode can be provided on an upper side of the sapphire substrate since sapphire serving as the substrate material is electrically insulating. Accordingly, a part of the semiconductor film needs to be exposed in order that electrodes may be provided on the group **III** nitride semiconductor film. For example, when the foregoing double hetero structure is exemplified, parts of the p-type GaN layer which is an uppermost layer, p-type GaAlN layer, InGaN layer and n-type GaAlN layer are eliminated in this order. An n-electrode is provided on the surface of the n-type GaN layer. A p-electrode is provided on the surface of the uppermost p-type GaN layer. Thus, etching needs to be carried out so that a part of the semiconductor is eliminated. The etching process results in damage in the crystal, constituting a cause for reduction in the performance of a semiconductor device.

Furthermore, GaN has a larger refractive index than glass or the like (for example, glass has a refractive index of 1.5 and GaN 2.5) and accordingly, reflection on an interface between crystal and space results in a problem. More specifically, when GaN is used, the aforesaid problem is a loss in emitted light in a light-emitting element and a reduction in light detecting sensitivity in a light detecting element. Thus, the aforesaid problem is an obstacle to making full use of each element's performance, whereupon it is difficult to manufacture a light-emitting element or light detecting element each having superior characteristics. Processes as multilayer film coating have conventionally been employed to overcome the problem. However, when the device is used with a shorter frequency than the ultraviolet region, it is difficult to maintain the properties of coating since a coating material which is an organic substance is serially damaged. Furthermore, in a process for making a mask pattern by photolithography, light employed for exposure has a wavelength of 248 nm of a KrF excimer laser at the shortest. Accordingly, it is impossible to make a fine mask of several nm to about one hundred nm on the surface of GaN.

The present invention was made in view of the foregoing and an object thereof is to provide a group **III** nitride semiconductor film having fewer lattice defects and a large film thickness and a method of fabricating the same, and another object is to provide a group **III** nitride semiconductor film having an eminent light detecting or emitting property and a method of fabricating the same.

### DISCLOSURE OF THE INVENTION

The inventors were devoted to the study of a method of fabricating a group **III** nitride semiconductor film such as a GaN compound semiconductor film and found that the object was achieved by forming a pillar-shaped structure (nano-pillars) in the order of nanometer consisting of a group **III** nitride semiconductor and depositing another group **III** nitride semiconductor film on the nano-pillars, thereby completing the present invention basically.

A first invention is a method of fabricating a group **III** nitride semiconductor film characterized by ① a nano-pillar fabricating step of fabricating nano-pillars by dry-etching a group **III** nitride semiconductor film while an etching retarding substance having a smaller etching rate than the group **III** nitride semiconductor is present on a surface of the group **III** nitride semiconductor (a lower layer) to be etched, and ② a depositing step of depositing another group **III** nitride semiconductor (an upper layer) on the nano-pillars, thereby making the group **III** nitride semiconductor film.

It is preferable that the etching retarding substance is placed as a solid substance in an etching chamber in the ① nano-pillar fabricating step so as to be exposed to an etching gas in dry etching.

Furthermore, it is preferable that the etching retarding substance is SiO₂.

A second invention is a group **III** nitride semiconductor film characterized in that a number of lattice defects ranges from 10²/cm² to 10⁸/cm² and a film thickness thereof ranges from 1 µm to 10⁴ µm. It is preferable that the group **III** nitride semiconductor film is fabricated by separating, at the nano-pillars, the group **III** nitride semiconductor film fabricated by the first invention.

A third invention is a methodof fabricating a group **III** nitride semiconductor film,characterized by ③ anano-pillarfabricating step of dry-etching a group **III** nitride semiconductor film while an etching retarding substance having a smaller etching rate than the group **III** nitride semiconductor film is present on a surface of the group **III** nitride semiconductor film, thereby fabricating nano-pillars.

The fabricated nano-pillars may be filled with ITO (Indium Tin Oxide), Al₂O₃, SiO₂ or the like. It is preferable that the substances filling the nano-pillars have respective refractive indexes ranging from 1 to 2.5. In this case, it is preferable that for example, a chemical etching is carried out in order that the etching retarding substance on the nano-pillar surfaces may be eliminated so that the elimination contributes to smooth formation of a filling layer. As a method of filling the nano-pillars is exemplified a metal organic vapor phase epitaxy method (MOVPE), a hydride VPE method (HVPE), a molecular beam epitaxy method (MBE) or the like.

The present invention will be described in more detail. A material for the group **III** nitride semiconductor film fabricated by the present invention is a group **III-V** semiconductor containing a group **III** element such as GaN, GaAlN, InGaN or the like (gallium, for example) and can generally be represented by chemical formula, AlₓGa_{y}In_{1-x-y}N (0≤x≤1, 0≤y≤1 and 0≤x+y≤1). These group **III** nitride semiconductor films may be pure or doped with impurity, which may be a p-type or n-type.

Furthermore, the group **III** nitride semiconductor film may have a monolayer or multilayer structure. When the group **III** nitride semiconductor film has a multilayer structure, all the layers may be formed of the group **III** nitride semiconductor film or at least one of the layers may be formed of the group **III** nitride semiconductor film. Furthermore, the group **III** nitride semiconductor film may be formed on a substrate of sapphire or the like, for example. The present invention may be employed for fabrication of a group **III** nitride semiconductor film having a multilayer structure such as a double heterostructure, for example.

The "etching retarding substance" is a substance having a smaller etching rate than the group **III** nitride semiconductor which is substantially a target substance, when the dry etching is carried out. When the etching retarding substance is present on the surface of the group **III** nitride semiconductor, a dry-etching speed becomes non-uniform on the target surface. Accordingly, etching is conducted slower on a part on which the etching retarding substance is present than another part on which the etching retarding substance is absent, whereupon a rugged structure (nano-pillars) is formed on the target surface (as will be described in detail later). As a concrete etching retarding substance are exemplified quartz (SiO₂), sapphire, nickel, organic resist or the like.

The "dry etching" is an etching method making use of gas discharge, differing from a chemical wet etching and includes for example, a reactive ion etching (RIE) , an electron cyclotron resonance etching (ECR) and an inductive coupling plasma etching (ICP).

"Present" means that the etching retarding substance is present on the surface of the group **III** nitride semiconductor in the order of nanometer (a range smaller than 1 µm). A method to obtain such a condition includes, for example, (i) a method of conducting etching while a solid etching retarding substance is placed in a chamber where the etching is conducted, whereby the etching retarding substance is produced by the sputtering in the etching chamber to be adhered to the surface of the group **III** nitride semiconductor, (ii) a method of causing the etching retarding substance to flow into the etching chamber, (iii) a method of previously dusting the etching retarding substance in the nanometer order onto the surface of the group **III** nitride semiconductor (the lower layer in the ① nano-pillar fabricating step) on which nano-pillars are to be formed.

The "nano-pillars" means a structure in which a plurality of small pillars each having a section sized in the nanometer order protrude. The nano-pillars have an exceedingly small probability of lattice defects which are present on the etched group **III** nitride semiconductor film. Moreover, the aforesaid lattice defects, even if the nano-pillars involve them, do not almost affect another group **III** nitride semiconductor film deposited with the top of each nano-pillar serving as a core of crystal growth. Furthermore, the light reflectance is reduced by providing nano-pillars on the surface of the group **III** nitride semiconductor film, whereby the light transmittance is improved. Accordingly, when a light emitting or light detecting device is manufactured using the group **III** nitride semiconductor film having the nano-pillars, the device has a better quality than the conventional one, that is, the light emitting efficiency is improved in the light emitting device and the sensitivity is improved in the light detecting device.

In the first or third invention, when the group **III** nitride semiconductor is dry-etched in the nano-pillar fabricating step (① or ③), the dry-etching is carried out while the etching retarding substance is present on the surface of the target group **III** nitride semiconductor. Since the etching retarding substance has a lower etching rate than the group **III** nitride semiconductor, the etching retarding substance serves as a micro-mask on a part of the surface to which the etching retarding substance is adherent, so that a micro rugged structure is formed at an initial stage of the etching. Since the electric field is higher in a slightly convex portion than in the concave portion, the subsequently ionized etching retarding substance will adhere to the convex portion with higher probability. Thus, it is supposed that re-adherence of the etching retarding substance and etching by an etching gas plasma repeatedly progress, whereby the nano-pillars are fabricated.

Describing a more concrete method, a group **III** nitride semiconductor film is placed on an upper side of one of a pair of positive and negative electrodes (parallel plate electrodes, for example) installed in an etching chamber where the internal pressure has been reduced to the order of 10⁻⁴ Pa, and high frequency power is applied to the aforesaid electrodes so that plasma is generated from a plasma generating gas while the etching retarding substance is present in the etching chamber. The group **III** nitride semiconductor film is etched by the plasma, whereby nano-pillars are fabricated. Most of the fabricated nano-pillars have a dimension of not more than about 100 nm and in addition, a space (gap) between adjacent nano-pillars can be ranged from several tens nm to about 100 nm on the average. Accordingly, the nano-pillar and the gap can repeatedly be constructed at a distance of about 100 nm. Then, nano-pillars whose maximum number is about 1×10⁶ are constructed for every 1 cm, and accordingly, nano-pillars whose maximum number is about 1×10¹² can be fabricated for every 1 cm².

In the nano-pillar fabricating step (① or ③), a type of the etching gas is not dependent but any type of gas which can generally be used in the dry etching of the group **III** nitride semiconductor may be employed. For example, an inert gas such as a Cl₂ gas, BCl₃ gas, SiCl₄ gas, SF₆ gas CHF₃ gas, CF₄ gas, CCl₂F₂ gas, CCl₄ gas, Ar or the like may be employed individually or in a mixture. In this case, it is preferable that a flow rate of gas ranges from 0.1 ml/min to 500 ml/min.

Furthermore, in the nano-pillar fabricating step (① or ③), it is preferable that the etching retarding substance as a solid is selected and placed in the etching chamber so as to be exposed to an etching gas plasma during the dry etching. As a result, the etching retarding substance is scattered into plasma by the sputtering effect during the etching and moreover, part of the scattered substance is ionized such that the etching retarding molecular adheres to the surface of the group **III** nitride semiconductor, whereupon the target group **III** nitride semiconductor is etched into nano-pillars. Since the etching retarding substance is placed in the etching chamber in the invention, condition control in the etching can be rendered easier.

As a form of the solid etching retarding substance used in the nano-pillar fabricating step (① or ③) is exemplified a form of wafer or a form of chip cut out of the wafer. Furthermore, as a general placing manner, the group **III** nitride semiconductor can be placed on the upper side of the solid etching retarding substance or the solid etching retarding substance can be placed near the group **III** nitride semiconductor. Further, an exposure area of the solid etching retarding substance (that is, an area of the solid etching retarding substance etched by the plasma) can suitably be determined according to the size of the group **III** nitride semiconductor to be etched and a distribution density of nano-pillars. More specifically, it is preferable that the exposure area of the solid etching retarding substance ranges from 2 to 100 relative to an exposure area of the group **III** nitride semiconductor. Further, when SiO₂ is used as the etching retarding substance, conventionally generally used mask substances can be used and accordingly, the invention can be put into practice without large changes in the conventional constitution.

In the nano-pillar fabricating step (① or ③), an internal pressure of the etching chamber in the dry etching is similar to that in the normal dry etching and can be set in a range from 0.01 Pa to 100 Pa, for example. Furthermore, a high frequency power density is the same as in the normal dry etching. For example, an electric power density can be set to range from 0.01 W/cm² to 10 W/cm². In the invention, it is preferable that silicon dioxide (SiO₂) is used as a mask applied to the surface of the group **III** nitride semiconductor. The reason for this is that silicon dioxide generally has a property that it cannot easily be etched by an etching gas plasma (for example, chlorine gas plasma).

In the first invention, another group **III** nitride semiconductor (an upper layer) is deposited on the nano-pillars which serves as cores comprising thus formed group **III** nitride semiconductor (a lower layer) (②a depositing step). In this case, it is preferable that for example, a chemical etching is carried out in order that the etching retarding substance on the nano-pillar surfaces may be eliminated completely so that the elimination contributes to smooth formation of the upper layer. As a method of depositing the upper layer is exemplified a metal organic vapor phase epitaxy method (MOVPE), a hydride VPE method (HVPE), a molecular beam epitaxy method (MBE) or the like.

Further according to the first invention, the probability that lattice defects present in the lower layer group **III** nitride semiconductor remains present in the nano-pillars is exceedingly small. Accordingly, the group **III** nitride semiconductor (an upper layer) involving fewer lattice defects is deposited on an upper face of the lower layer. In addition to this, the upper layer is deposited on the nano-pillars comprising the group **III** nitride semiconductor having the same physical properties such as the lattice constant as the upper layer. Accordingly, the upper layer is exceedingly stable as compared with the case where the upper layer is deposited on an upper face of the substance having a different lattice constant and thermal expansion coefficient such as sapphire as in the conventional structure. Consequently, the group **III** nitride semiconductor film having such a large film thickness as was not able to be obtained conventionally. Thus, by separating the nano-pillars from the upper layer by the process of the present invention, the group **III** nitride semiconductor film can be provided in which the number of lattice defects ranges from 10²/cm² to 10⁸/cm² or more preferably, from 10²/cm² to 10⁵/cm² or further more preferably, from 10²/cm² to 10³/cm² and the film thickness ranges from 0.1 µm to 10⁴ µm or more preferably, from 1 µm to 10⁴ µm or further more preferably 1 µm to 5×10² µm or still further more preferably, from 1 µm to 10⁴ µm.

A method of separating the nano-pillars from the upper layer includes physical methods (for example, cutting by a sharp blade or a cutter provided with a substance having a high hardness, such as diamond or breaking the nano-pillars by application of impulse or shearing stress) and chemical methods (melting only the nano-pillars by soaking them in an etchant, thereby separating the nano-pillars). Furthermore, it is preferable that the face on which the nano-pillars are located is ground and flattened.

Further another group **III** nitride semiconductor film is grown on the aforesaid semiconductor film serving as a substrate, whereupon optical devices such as light emitting elements, bipolar devices such as transistors and unipolar devices such as FET's can be fabricated.

The third invention is a process of fabricating a light emitting device including nano-pillars on the surface of the group **III** nitride semiconductor film or a light detecting device. The ③ nano-pillar fabricating step is carried out in the same manner as in the ① nano-pillar fabricating step in the first invention. The nano-pillars are provided on the surface of the group **III** nitride semiconductor film in the present invention. Furthermore, in the ③ nano-pillar fabricating step, a suitable mask is provided on the surface such that a predetermined pattern can be formed.

According to the first invention, the group **III** nitride semiconductor film having no stress-strain, fewer lattice defects and a large thickness can efficiently be fabricated in a short period of time. Furthermore, the mixed crystal involving fewer lattice defects, AlₓGa_{y}In_{1-x-y}N (0≤x≤1, 0≤y≤1 and 0≤x+y≤1), is formed on the aforesaid group **III** nitride semiconductor film, whereby a multilayer film can be formed. Consequently, light emitting and detecting devices having high light emitting and detecting efficiencies respectively can be provided.

Furthermore, the group **III** nitride semiconductor film (the upper layer) fabricated in accordance with the present invention is separated, with the nano-pillars serving as a boundary, ) from the sapphire substrate, the buffer layer and the group **III** nitride semiconductor film (the lower layer) involving stress-strain and a large number of lattice defects, all of which are present on the lower layer, whereby the group **III** nitride semiconductor film can be fabricated into a group **III** nitride semiconductor film. Consequently, a back electrode (which is conventionally provided on the semiconductor film nearer to the sapphire substrate) can easily be fabricated and steps can be simplified. Additionally, the freedom in the design such as an increase in an effective light emitting area can be increased.

According to the third invention, the nano-pillars having a distribution density of 10⁶/cm² to 10¹²/cm² can easily be provided although these nano-pillars cannot conventionally be fabricated stably. Furthermore, the group **III** nitride semiconductor film fabricated in accordance with the present invention has an improved light reflectance and transmittance (that is, the reflectance is reduced and the transmittance is increased). Consequently, the light emitting device with an improved reflectance and transmittance can be provided.

Particularly when AlGaN or AlN each containing Al as the group **III** nitride semiconductor is used, it is supposed that the reflectance can be improved regarding short waves (for example, about 200 nm) and accordingly, desirable optical devices can be provided with respect to light in the ultraviolet region although such optical devices were not conventionally provided.

### BRIEF DESCRIPTION OF THE DRAWINGS

FIG. 1 is a sectional view of an etching apparatus which can be used in the practice of the present invention;
FIGS. 2A and 2B illustrate a sapphire substrate serving as a base for the group **III** nitride semiconductor and AlN buffer layer formed on the surface of the sapphire substrate, respectively, both figures showing the procedure of forming nano-pillars;
FIGS. 3C and 3D illustrate a GaN layer serving as the group **III** nitride semiconductor and formed on the surface of the buffer layer and nano-pillars formed on the surface of the GaN layer, respectively, both figures showing the procedure of forming nano-pillars;
FIG. 4 is a sectional view of the nano-pillars on which the group **III** nitride semiconductor is deposited;
FIG. 5 is a typical sectional view of the nano-pillars on which the group **III** nitride semiconductor is deposited, showing crystal transition defects (lattice defects);
FIG. 6 is an electron microscope photograph showing a section of crystal structure of an etched surface after the group **III** nitride semiconductor has been etched by the method described in embodiment 1;
FIG. 7 is an electron microscope photograph showing a section of crystal structure of an etched surface after the group **III** nitride semiconductor has been etched by the method described in embodiment 1, the crystal structure being viewed from obliquely upward;
FIG. 8 is a sectional view showing nano-pillars being cut with a diamond cutter;
FIG. 9 is a sectional view showing nano-pillars with masks being applied at predetermined positions;
FIG. 10 is a sectional view showing an example of a light detecting device structure in which nano-pillars are provided on the group **III** nitride semiconductor;
FIG. 11 is a sectional view showing an example of a light emitting device (LED) structure in which nano-pillars are provided on the group **III** nitride semiconductor;
FIG. 12 is a sectional view of the group **III** nitride semiconductor in the case where the nano-pillars are filled with a filling substance such as SiO₂;
FIG. 13 is a graph showing the reflectance of the group **III** nitride semiconductor film provided with nano-pillars, wherein the axis of abscissas denotes the wavelength (nm) and the axis of ordinates denotes the reflectance, and the broken line represents the reflectance of a conventional group **III** nitride semiconductor film and the solid line represents the reflectance of the group **III** nitride semiconductor film provided with the nano-pillars; and
FIG. 14 is a graph showing the transmittance of the group **III** nitride semiconductor provided with nano-pillars, wherein the axis of abscissas denotes the wavelength (nm) and the axis of ordinates denotes the transmittance, and the broken line represents the transmittance of a conventional group **III** nitride semiconductor film and the solid line represents the transmittance of the group **III** nitride semiconductor film provided with the nano-pillars.

In the figures, reference symbol 1 designates an etching chamber, 2 a high-frequency power supply, 3 an exhaust pipe, 4a and 4b gas supply pipes, 11 and 12 electrodes, 101 GaN (group **III** nitride semiconductor film) and 56 a quartz substrate.

### BEST MODE FOR CARRYING OUT THE INVENTION

Embodiments of the present invention will now be described in detail with reference to the drawings. However, the present invention should not be limited by the following embodiments but may be changed into various modes without departing from the essence of the present invention. Furthermore, the technical scope of the present invention should cover a scope of equality.

### 1. Best mode for carrying out the first invention:

The best mode for carrying out the first invention (that is, a method of fabricating a group **III** nitride semiconductor film including ①a nano-pillar fabricating step and ②a depositing step) will be described.

### <Nano-pillar fabricating step>

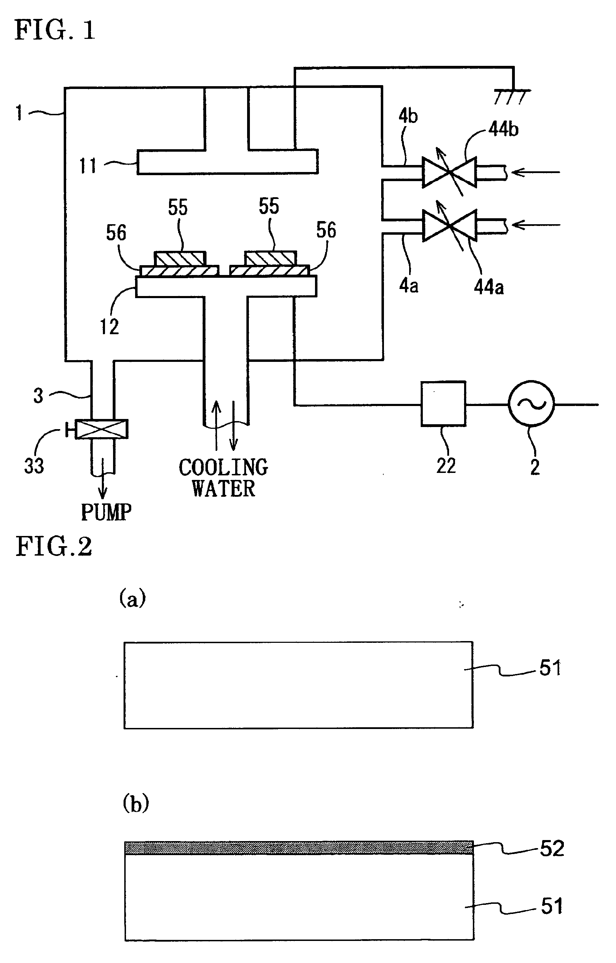

FIG. 1 is a sectional view of an example of dry etching apparatus which can be used in the practice of the present invention. The apparatus includes an etching chamber 1, a high-frequency power supply 2, an exhaust apparatus and a plasma generating gas supply apparatus.

More specifically, a pair of positive and negative parallel flat plate-shaped electrodes 11 and 12 are installed so as to be opposed to each other in the etching chamber 1 made of stainless steel 1, for example. Of both electrodes, the anode 11 is maintained at an earth potential whereas a high-frequency power is applied to the cathode 12. The cathode 12 is beaten by plasma gas hard such that the temperature thereof is increased. Accordingly, the cathode 12 has a hollow interior structure so that cooling water is allowed to flow through the rear side thereof in order to cool the cathode. A high-frequency power supply 2 of 13.56 MHz is connected via a matching box 22 to the cathode 12, so that plasma is controlled.

The exhaust pipe 3 is provided in the etching chamber 1. An exhauster (not shown) including a combination of a dry pump, turbo pump and the like is connected to the exhaust pipe 3. The exhauster is driven so that the interior of the etching chamber 1 is evacuated, whereby pressure in the etching chamber is reduced to or below 10⁻⁴ Pa. The pressure in the etching chamber 1 is adjusted by a pressure adjusting valve 33 provided in the middle of the exhaust pipe 3, for example, so that the interior of the etching chamber is maintained in a predetermined range of vacuum.

The etching chamber 1 is provided with gas conduits 4a and 4b introducing plasma generating gases respectively therein. The other ends of the gas conduits 4a and 4b are connected to external plasma generating gas sources (not shown) respectively. More specifically, the etching chamber 1 is provided with the first gas conduit 4a introducing an etching gas (chlorine gas, for example) therein and the second gas conduit 4b introducing another gas (mixed with the first gas for dry etching, if necessary). Flow rates of the gases are controlled by a massflow controllers 44a and 44b provided across the gas conduits 4a and 4b respectively. The gas conduit 4b is eliminated or closed when only the first gas is introduced into the etching chamber 1 as the plasma generating gas.

An operation for etching the group **III** nitride semiconductor film using the foregoing etching apparatus 1 (a nano-pillar fabricating step) will now be described. In the following example, a step of fabricating nano-pillars on the surface of a GaN layer is exemplified. However, the technical scope of the present invention should not be limited to this but covers methods of fabricating nano-pillars on the surfaces of group **III** nitride semiconductor films represented by formula, AlₓGa_{y}In_{1-x-y}N (0≤x≤1, 0≤y≤1 and 0≤x+y≤1).

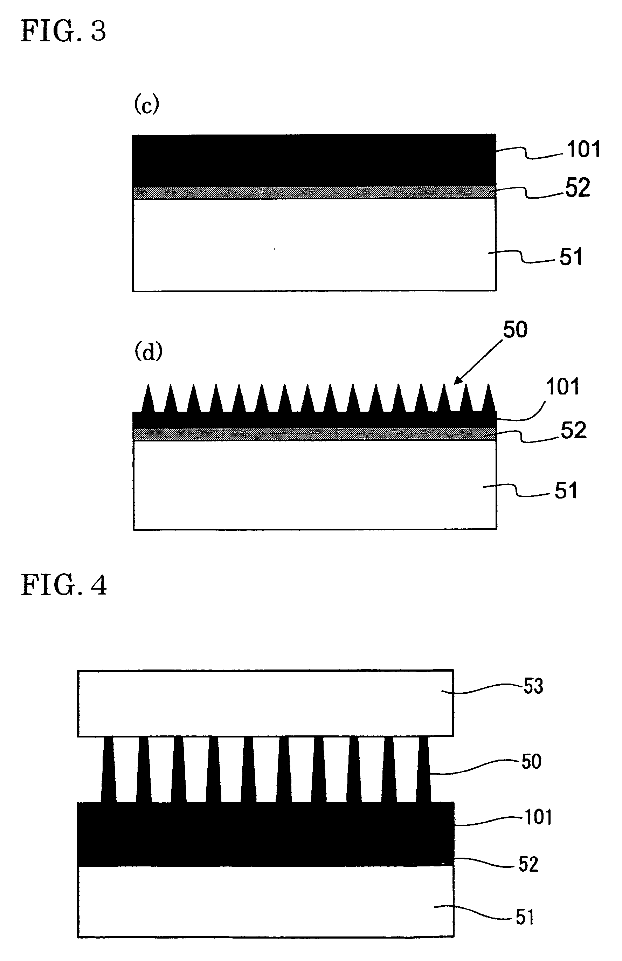

Firstly, the structure of the group **III** nitride semiconductor film will be described with reference to FIGS. 2A, 2B and 3. The group **III** nitride semiconductor film is provided on an upper side of a buffer layer 52 which is further provided on an upper side of a sapphire substrate 51, for example, as shown in FIGS. 2A and 2B. AlN having a thickness of about 20 nm can be used as the buffer layer 52.

A group **III** nitride semiconductor film 101 (for example, GaN can be used) is formed on the upper side of the buffer layer 52, for example, by an MOVPE method (FIG. 3C).

In order that the sample 55 having such a structure (meaning an overall substance including the buffer layer 52 on the surface of the sapphire substrate 51 and the semiconductor film 101) may be etched, a solid quartz substrate 56 is placed on the upper side of each cathode 12 and a wafer of the sample 55 is placed on or around the quartz substrate. When the sample 55 is placed on the upper side of the quartz substrate 56, a section of the quartz substrate 56 is rendered larger than a section of the sample 55 so that the quartz substrate is exposed to the etching gas.

The exhauster is then driven so that the etching chamber 1 is exhausted so that the interior pressure is in the order of 10⁻⁴ Pa. After the degree of vacuum has become stable, the chlorine gas is introduced from gas conduit 4a into the interior of the etching chamber 1 while the flow rate is controlled by the massflow controller 44a so that a predetermined flow rate is achieved. In this case, at the same time, the etching chamber 1 is exhausted by the exhauster and the pressure adjusting valve 33 is adjusted so that the internal pressure of the etching chamber 1 becomes a predetermined pressure. Chlorine gas plasma is generated between both electrodes 11 and 12 when voltage from the high-frequency power supply 2 is applied via the matching box 22 after the internal pressure of the etching chamber 1 has been stabilized.

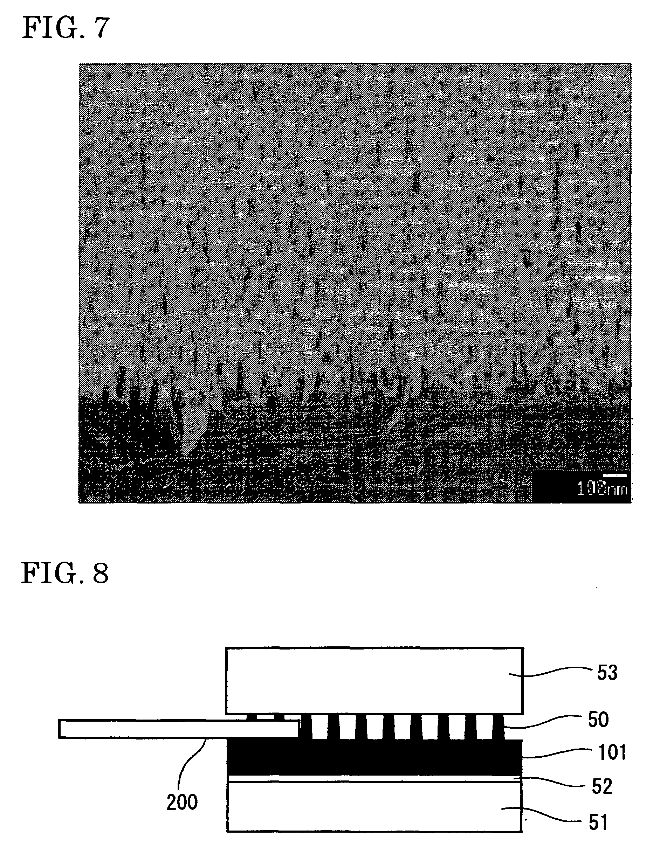

The chlorine gas sputters and etches the group **III** nitride semiconductor film 101 of the sample 55 while etching the quartz substrate 56 (the nano-pillar fabricating step). Nano-pillars 50 are thus formed on the surface of the group **III** nitride semiconductor film 101 by the etching, as shown in FIG. 8D. Each nano-pillar 50 has a diameter ranging from about 10 nm to about 200 nm. A space between each nano-pillar 50 and another nano-pillar 50 adjacent thereto is about 100 nm on the average. The diameter and space of the nano-pillars 50 can be changed suitably according the conditions of the etching. A mask in the order of nanometer is required when an ordinary lithography is used for formation of the above-described nano-pillars. Furthermore, a wavelength in the order of nanometer is also necessary for light used in the exposure. Consequently, a method using the lithography cannot currently be realized.

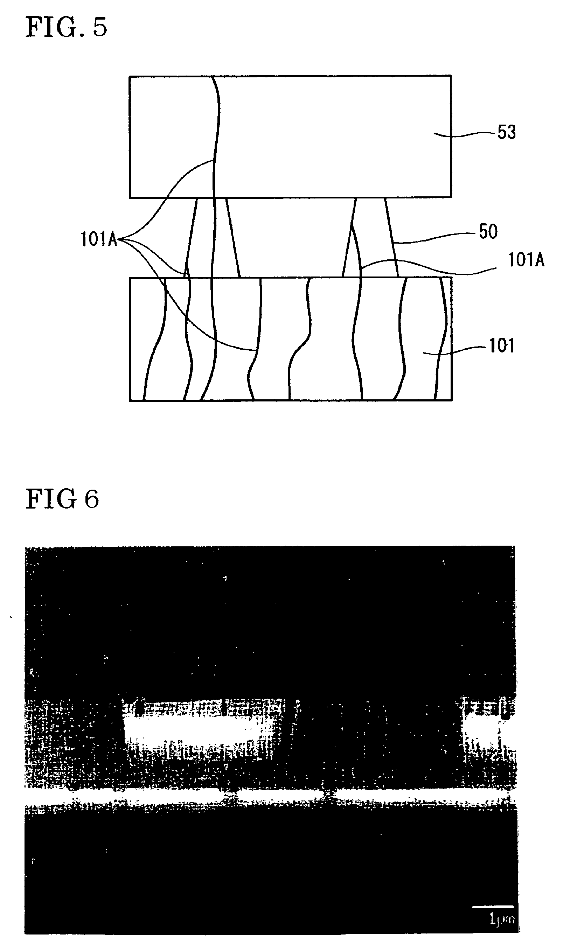

When the nano-pillars 50 have thus been fabricated, most of lattice defects 101A present in the lower layer of group **III** nitride semiconductor 101 are interrupted from proximal ends of the nano-pillars 50 to the middle portions, as shown in FIG. 5. Consequently, the lattice defects are prevented from being taken over to upper portions of the nano-pillars (that is, portions serving as a footing for a group **III** nitride semiconductor film 53 serving as an upper layer). Accordingly, very few lattice defects 101A are present on the group **III** nitride semiconductor 53 (the upper layer) deposited on the upper faces of the nano-pillars 50.

### <Depositing step>

The new group **III** nitride semiconductor 53 is then deposited on the upper sides of the nano-pillars 50 as shown in FIG. 4 (the depositing step). The depositing method includes the MOVPE method, HVPE method, MBE method, as described above.

When the new group **III** nitride semiconductor 53 (the upper layer) has been obtained, the semiconductor is cut between the upper layer 53 and the nano-pillars 50, whereby the simple upper layer 53 is obtained. As a method of cutting the upper layer from the nano-pillars 50, for example, a diamond cutter 200 as shown in FIG. 8 may be used. Further another group **III** nitride semiconductor 53 may be deposited on the upper side of the simple upper layer 53 serving as a substrate.

### 2. Best mode for carrying out the third invention:

A best mode for carrying out the third invention will now be described.

### (1) Method of fabricating a light detecting device:

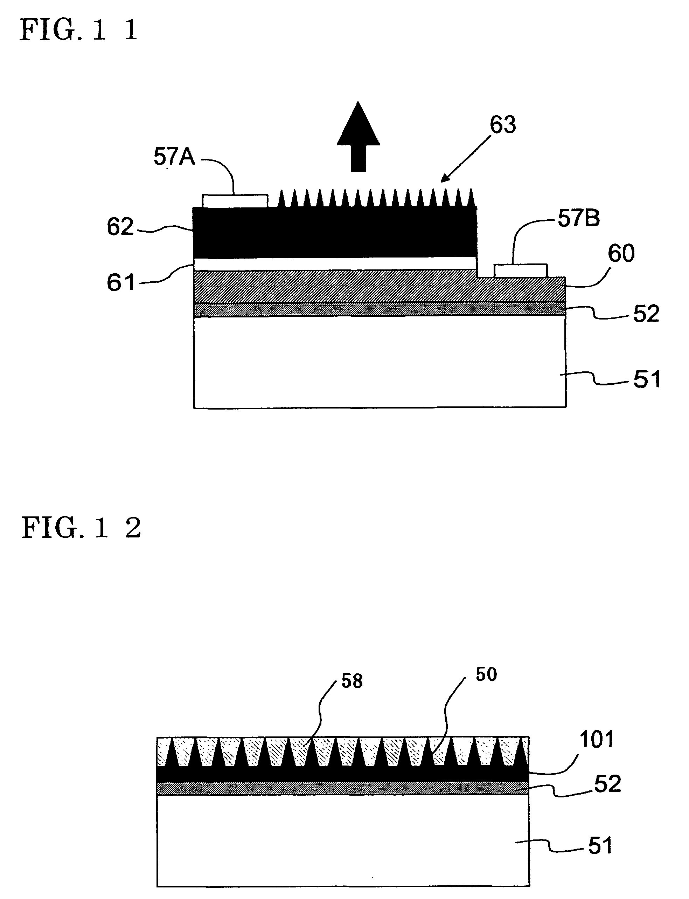

A light detecting device has such a structure that the buffer layer 52 is laminated on the upper side of the sapphire substrate 51 and the GaN layer 101 provided with the nano-pillars 50 is laminated on the buffer layer as shown in FIG. 10.

③ the nano-pillar fabricating step can be carried out in the same manner as <the nano-pillar fabricating step> in "1. Best mode for carrying out the first invention." Accordingly, the description will be eliminated so that repetition is avoided.

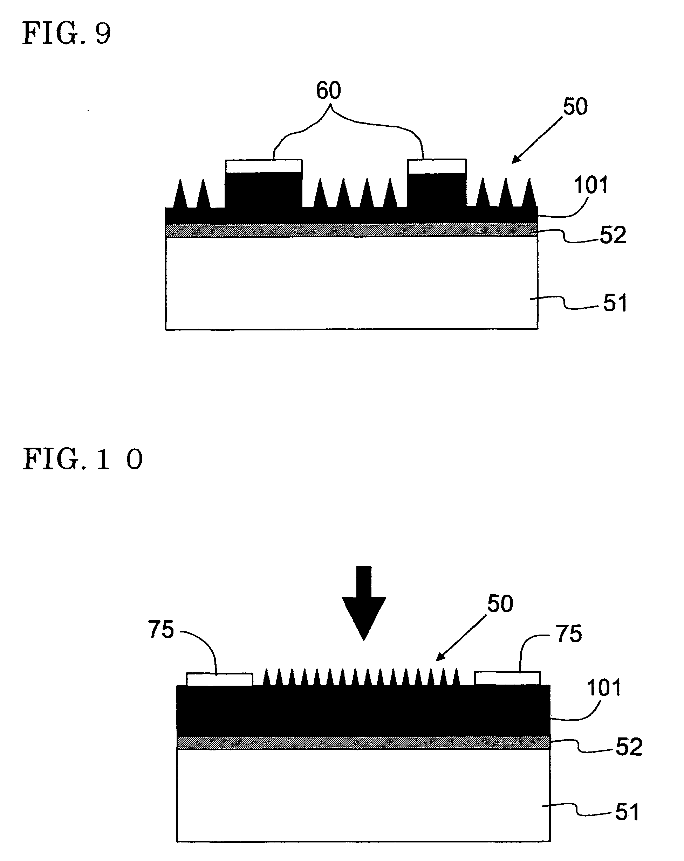

In fabricating the nano-pillars 50, etching may be carried out with suitable masks 60 (SiO₂, for example) being applied, whereby a group **III** nitride semiconductor film with a predetermined pattern on its surface can be fabricated as shown in FIG. 9.

Furthermore, electrodes 57 are formed at predetermined positions where no nano-pillars 50 have been fabricated by application of masks, whereby a light detecting device as shown in FIG. 10 can be made.

### (2) Process for fabricating a light-emitting device:

A light-emitting device can be constructed as shown in FIG. 11. The light-emitting device as shown in FIG. 11 comprises a group **III** nitride semiconductor film formed by laminating an n-GaN layer 60 (a first semiconductor layer) , an InGaN layer 61 (a second semiconductor layer 61 and serving as light-emitting layer) and a p-GaN layer 62 (a third semiconductor layer) all laminated on a substrate provided with the buffer layer 52 provided on the upper side of the sapphire substrate 51, for example, by MOVPE method, sequentially in this order. In the aforesaid structure, the second semiconductor layer is sandwiched between the first and second semiconductor layers. In order that the light-emitting device may perform a desired operation, it is preferable that selection is made so that the second semiconductor layer is made of such a substance that the band gap energy of the second semiconductor layer is smaller than the band gap energy of the first semiconductor layer and the band gap energy of the third semiconductor layer. The first semiconductor layer may have a thickness of about several hundreds to several thousands nm. The second semiconductor layer may have a thickness of about several nm to about 60 nm. The third semiconductor layer may have a thickness of about several nm to one hundrednm. Furthermore, the paired positive and negative electrodes 57A and 57B are provided on the p-GaN layer 62 and n-GaN layer 60 respectively.

A procedure for fabricating nano-pillars on the outermost layer will be described. The n-GaN layer 60, InGaN layer 61 and p-GaN layer 62 are grown via the buffer layer 52 on the upper side of the sapphire <0001> substrate, for example, by the MOVPE method. In this case, each of the n-GaN and p-GaN layers 60 and 62 has a thickness of about 300 nm and the InGaN layer 61 has a thickness of about 20 nm. Furthermore, SiO2 is deposited on the upper side, for example, by the RF sputtering, so as to have a thickness of about 300 nm and a line of 5 µm wide and space pattern are fabricated in the <1100> direction by the ordinary photolithography technique, whereby an etching sample 55 is made. The same operation is carried out as in the <nano-pillar fabricating step> in "1. Best mode for carrying out the first invention" except for use of the sample 55, whereupon nano-pillars 63 can be fabricated on the surface of p-GaN layer 62.

A pair of positive and negative electrodes 57A and 57B are formed on the group **III** nitride semiconductor film thus fabricated. The positive electrode 57A is formed on the upper side of the p-GaN layer 62. The negative electrode 57B is formed on the surface of the n-GaN layer 60 after a depression has been formed by the etching so as to extend through the p-GaN layer 62 and InGaN layer 61 and reach the n-GaN layer 60.

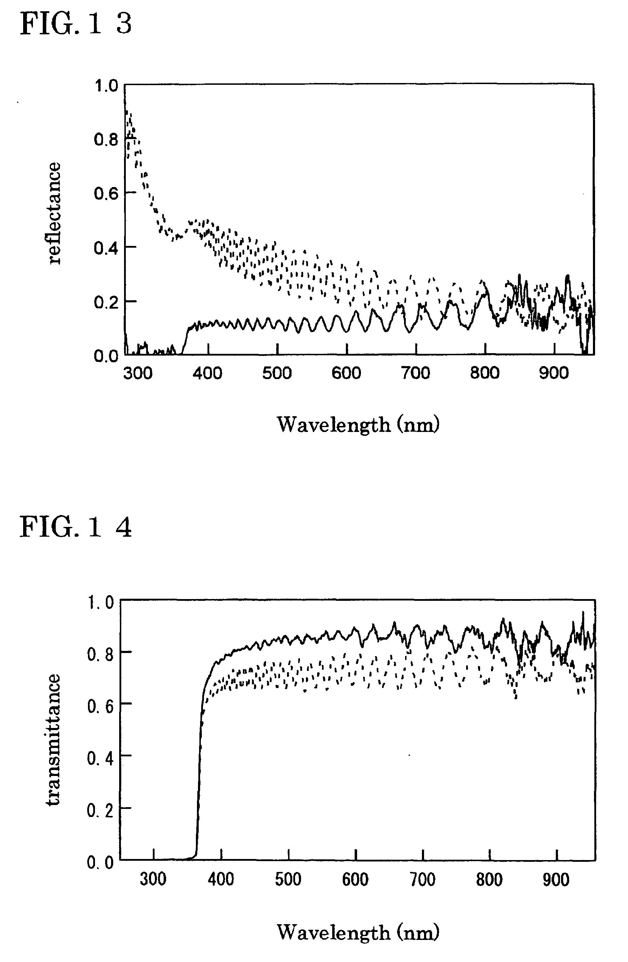

After fabrication of the nano-pillars 50, spaces between the nano-pillars 50 may be filled with a suitable filling material 58 (for example, ITO (indium tin oxide) , Al₂O₃, SiO₂ or the like) as shown in FIG. 12 (the filling step). It is preferable that a chemical etching is carried out in order that the etching retarding substance on the nano-pillar surfaces maybe eliminated so that the elimination contributes to smooth formation of a filling layer. As a method of filling the nano-pillars 50 is exemplified a metal organic vapor phase epitaxy method (MOVPE) , a hydride VPE method (HVPE), a molecular beam epitaxy method (MBE) or the like.

### <Embodiments>

### (1) Nano-pillar fabricating step:

GaN (gallium nitride) was grown on a sapphire <0001> substrate by the MOVPE method so as to have a thickness of 2 µm to 3 µm and was used as the group **III** nitride semiconductor (the lower layer).

SiO₂ was deposited on the upper side of GaN, for example, by the RF sputtering, so as to have a thickness of about 300 nm and a line of 5 µm wide and space pattern were fabricated in the <1100> direction by the ordinary photolithography technique, whereby an etching sample 55 was made.

The quartz substrate 56 was installed on a stage of the etching chamber 1. The etching sample 55 was placed around the quartz substrate 56 and on the upper side of the quartz substrate.

Thereafter, the etching chamber 1 was exhaustedby the vacuum pump so that the internal pressure was reduced to 5×10⁻⁴ Pa. After the degree of vacuum had become stable, the chlorine gas was introduced from gas conduit 4a into the interior of the etching chamber 1 while the flow rate was controlled by the massflow controller 44a so that a flow rate of 30 ml/min was achieved. At the same time, the etching chamber 1 was exhausted by the vacuum pump and the pressure adjusting valve 33 was adjusted so that pressure reduction by 6 Pa was achieved.

After stabilized degree of vacuum in the etching chamber 1 had been confirmed, voltage from the high-frequency power supply 2 was applied so that plasma was generated between both electrodes 11 and 12. The dry etching was carried out for about four minutes under the condition of 100 W (an area of 177 cm²).

The sample 55 was taken out of the etching chamber 1 after the dry etching and the etched side was observed by a scanning electron microscope (SEM). FIGS. 6 and 7 are views showing photographs of etched side structure of GaN taken by SEM during the observation. According to the embodiment, a chlorine ion in the plasma strikes the quartz substrate around GaN, whereupon SiO₂ moves out into the plasma by the sputtering effect. It is supposed that part of SiO₂ is ionized thereby to re-adhere to the negative biased GaN film. Since SiO₂ has an etching rate of one-tenth to one-twentieth relative to the chlorine gas plasma, which value is lower as compared with GaN, SiO₂ serves as a micro-mask, whereupon a micro rugged structure is formed on the surface of the sample 55. Since the electric field is higher in a slightly convex portion than in the concave portion, the subsequently ionized SiO₂ will adhere to the convex portion with a higher probability. Thus, it is supposed that re-adherence of the etching retarding substance and etching by an etching gas plasma repeatedly progress, whereby the nano-pillars are fabricated. The nano-pillar had a thickness of about several tends nm to several hundreds nm and a height of about 500 nm. Furthermore, the nano-pillars had a distribution density of 10⁶/cm² to 10¹²/cm². It became clear that the height of the nano-pillar depended largely upon the etching time.

### (2) Depositing step:

Another GaN (an upper layer) was able to be grown on the upper side of GaN of the nano-pillars thus fabricated, for example, by the MOCVD method (see FIG. 4). As the conditions in this case, trimethyl gallium (TMG) was caused to flow at 48 µmol/min and NH₃ was caused to flow at µmol/min. The temperature was 1000°C and pressure was 300 Torr. Under these conditions, the growth of GaN by about 3 µm to 4 µm per hour was confirmed. GaN of the upper layer had a film thickness of about 3 µm.

### (3) Separating step:

The upper layer was cut from the nano-pillars using a diamond cutter so as to be separated from the nano-pillars. FIG. 8 illustrates a manner of separating the upper layer 53 by pressing a rotary diamond cutter along the nano-pillars 50. The rear side (on which the nano-pillars were present) of the upper layer 53 thus obtained as a single body was ground and flattened. Thus, the GaN semiconductor film having fewer lattice defects and a larger film thickness was able to be obtained. Differing from the prior art (that is, the GaN layer provided on the upper side of the non-conductive sapphire substrate), the upper layer 5 is a monolayer of GaN and no other substrate is present at the rear side thereof.

When the aforesaid GaN film is used as a substrate, crystallinity suitable for a group **III** nitride semiconductor layer grown on the upper side thereof is obtained. Furthermore, this substrate can be afforded the electrical conductivity, differing from the conventional sapphire substrate. Accordingly, electrodes can be formed both sides of a group **III** nitride semiconductor element. Consequently, the number of steps in the fabrication of semiconductor element can be reduced and a cost reduction can be achieved in the present invention as compared with the conventional semiconductor elements.

### Embodiment 2: Characteristic evaluation of the group III nitride semiconductor film provided with nano-pillars:

Characteristics of the foregoing group **III** nitride semiconductor film provided with nano-pillars were evaluated. FIG. 12 is a graph showing the relationship between the wavelength and reflectance and FIG. 13 is a graph showing the relationship between the wavelength and transmittance.

Regarding the reflectance and transmittance, data of GaN with nano-pillars (solid line) and GaN without nano-pillars (broken line) were compared with each other. In each graph, a cyclic oscillation is due to light interference by the GaN film. In a range of wavelength shorter than 800 nm, both reflectance and transmittance are effective (that is, the reflectance is reduced and the transmittance is improved). Regarding the nano-pillars, the reflectance is approximate to zero in a range of wavelength shorter than about 360 nm corresponding to a band gap of GaN. In a wavelength range not more than the band gap, the transmittance necessarily becomes zero since light is absorbed into GaN (FIG. 13). However, since the transmittance is improved in a wavelength range longer than the band gap, it is supposed that light is absorbed into the GaN crystal efficiently without being reflected in the case of the nano-pillars in a wavelength range not more than the band gap.

## Claims

1. A method of fabricating a group **III** nitride semiconductor film **characterized by**:
①a nano-pillar fabricating step of fabricating nano-pillars by dry-etching a group **III** nitride semiconductor film while an etching retarding substance having a smaller etching rate than the group **III** nitride semiconductor is present on a surface of the group **III** nitride semiconductor (a lower layer) to be etched; and
②a depositing step of depositing another group **III** nitride semiconductor (an upper layer) on the nano-pillars, there by making the group **III** nitride semiconductor film.

2. The method of fabricating a group **III** nitride semiconductor film according to claim 1, **characterized in that** the etching retarding substance is placed as a solid substance in an etching chamber in the nano-pillar fabricating step so as to be exposed to an etching gas in dry etching.

3. The method of fabricating a group **III** nitride semiconductor film according to claim 1 or 2, **characterized in that** the etching retarding substance is SiO₂.

4. A group **III** nitride semiconductor film **characterized in that** a number of lattice defects ranges from 10²/cm² to 10⁸/cm² and a film thickness thereof ranges from 1 µm to 10⁴ µm.

5. A group **III** nitride semiconductor film made by separating, at the nano-pillars, the group **III** nitride semiconductor film made by the process of any one of claims 1 to 3.

6. A method of fabricating a group **III** nitride semiconductor film, **characterized by** ③ a nano-pillar fabricating step of dry-etching a group **III** nitride semiconductor film while an etching retarding substance having a smaller etching rate than the group **III** nitride semiconductor film is present on a surface of the group **III** nitride semiconductor film, thereby making nano-pillars.

7. A group **III** nitride semiconductor film **characterized in that** the group **III** nitride semiconductor film has, on a surface thereof, nano-pillars having a distribution density ranging from 10⁶/cm² to 10¹²/cm².

8. A light emitting device comprising the group **III** nitride semiconductor defined by claim 7.

9. A light detecting device comprising the group **III** nitride semiconductor defined by claim 7.
